(19) Europäisches Patentamt

European Patent Office

Office européen des brevets

(11) **EP 1 285 900 B1**

(12) **EUROPÄISCHE PATENTSCHRIFT**

(45) Veröffentlichungstag und Bekanntmachung des Hinweises auf die Patenterteilung:
**16.02.2005 Patentblatt 2005/07**

(51) Int Cl.⁷: **C04B 41/88**, C23C 4/12, C23C 16/513, C22C 47/04

(21) Anmeldenummer: **02018049.3**

(22) Anmeldetag: **13.08.2002**

(54) **Vorrichtung zur Beschichtung von Siliziumcarbidfasern**

Device for coating silicon carbide fibers

Appareil pour revêtir des fibres en carbure de silicium

(84) Benannte Vertragsstaaten:
**AT BE BG CH CY CZ DE DK EE ES FI FR GB GR IE IT LI LU MC NL PT SE SK TR**

(30) Priorität: **17.08.2001 DE 10140465**

(43) Veröffentlichungstag der Anmeldung:
**26.02.2003 Patentblatt 2003/09**

(73) Patentinhaber:
- **MTU Aero Engines GmbH**
  **80995 München (DE)**
- **DaimlerChrysler AG**
  **70567 Stuttgart (DE)**

(72) Erfinder:
- **Bayer, Erwin, Dr.**
  **85221 Dachau (DE)**
- **Höschele, Jörg, Dr.**
  **88074 Meckenbeuren (DE)**
- **Kopperger, Bertram**
  **85241 Hebertshausen (DE)**
- **Steinwandel, Jürgen, Dr.**
  **88690 Uhldingen-Mühlhofen (DE)**

(74) Vertreter: **Lindner-Vogt, Karin, Dipl.-Phys. et al DaimlerChrysler AG,
Intellectual Property Management,HPC C 106
70546 Stuttgart (DE)**

(56) Entgegenhaltungen:
**EP-A- 0 358 799**

- **DATABASE COMPENDEX [Online] ENGINEERING INFORMATION, INC., NEW YORK, NY, US; VALENTE T ET AL: "Fabbricazione di compositi a matrice di titanio e fibre continue mediante plasma spray in alta pressione" Database accession no. E2001326606000 XP002248961 & METALL ITAL;METALLURGIA ITALIANA 2001, Bd. 93, Nr. 5, 2001, Seiten 37-41,**

**Beschreibung**

Die Erfindung betrifft eine Vorrichtung zur Beschichtung von Siliziumkarbidfasern nach dem Oberbegriff des Patentanspruchs 1.

Aus EP-B-0 615 966 ist bekannt, dass zur Beschichtung von Siliziumkarbidfasern mit einer Metallmatrix PVD-Verfahren (physical vapor deposit) oder Sputter-Verfahren verwendet werden.

Ein Verfahren zur Ausbildung faserverstärkter Metallmatrixelemente ist aus EP-A-0 358 799 bekannt, bei dem Siliziumkarbidfasern auf einem Substrat in Titanbasismetall eingebettet werden. Die Beschichtung erfolgt in dem bekannten Verfahren mittels eines Niederdruck-Hochfrequenz-Plasmaspritzprozesses. Das Feststoff-Titanbasismetall wird dem Prozessgas dabei in Pulverform zugegeben.

Ein Nachteil dieses Verfahrens ist die ineffektive und teure Herstellung der Beschichtungen. Außerdem ist mit dem bekannten Plasmaspritzverfahren im Niederdruckbereich eine Beschichtung der Siliziumkarbidfasern in einer Produktionslinie nicht möglich, da in einem evakuierbaren Behälter gearbeitet werden muss.

Die Veröffentlichung VALENTE T ET AL: "Fabbricazione di compositi a matrice di titanio e fibre continue mediante plasma spray in alta pressione" METALLURGIA - ITALIANA 2001, Bd 93, Nr. 5, 2001, Seiten 37-41, Compendex - Zusammenfassung behandelt die Herstellung von Komposit-Monotapes mit Sitiziumkarbid-Langfasern in einer Titanbasislegierung als Matrix. Dabei wird Hochdruck-Plasmaspritzen zur Einbettung der Fasern in das Matrixmetall vorgeschlagen.

Aufgabe der Erfindung ist es, eine neue Vorrichtung anzugeben, mit der es möglich ist, eine einfache und effektive Beschichtung von Siliziumkarbidfasern in einer Produktionslinie zu erreichen.

Diese Aufgabe wird gemäß Patentanspruch 1 erfüllt. Vorteilhafte Ausführungen der Erfindung sind Gegenstand von Unteransprüchen.

Erfindungsgemäß sind mindestens zwei Hochdruck-Plasmabrenner symmetrisch derart zueinander angeordnet, dass sich die Plasmastrahlen in einem Punkt treffen, durch den die Siliziumkarbidfasern laufen. Mittels Absorption von Mikro- oder Radiowellen wird das Hochdruckplasma aufrechterhalten. Jeder Hochdruck-Plasmabrenner weist eine Düse für den Austritt des Plasmastrahls auf.

Der Vorteil dabei ist eine effektive und schnelle Beschichtung der Siliziumkarbidfasern. Im Gegensatz zum Stand der Technik muss die erfindungsgemäße Vorrichtung nicht im Vakuum arbeiten. Hieraus ergeben sich weitere Vorteile hinsichtlich einer verbesserten Produktivität und Effizienz, weshalb die erfindungsgemäße Vorrichtung geeignet für den Einsatz in einer Produktionslinie ist.

Den Hochdruck-Plasmabrennem kann in einer vorteilhaften Ausführung der Erfindung die Titanbasislegierung als Flüssig- und /oder Feststoffprecursor zugeführt werden. Als Flüssigprecursor kann dabei Titantetrachlorid ($TiCl_4$) und als Feststoffprecursor kann ein Titanbasis-Legierungspulver verwendet werden.

Bei der Verwendung von $TiCl_4$ als Flüssigprecursor im Prozessgas treten im Plasma insbesondere folgende Reaktionen auf:

$$TiCl_4 + 2\,H_2 \rightarrow Ti + 4\,HCl \qquad (1)$$

$$TiCl_4 + 4\,H \rightarrow Ti + 4\,HCl \qquad (2)$$

Reaktion (1) ist dabei im Gegensatz zu Reaktion (2) thermodynamisch limitiert. Dies bedeutet, dass aufgrund der hohen Temperatur in einem Hochdruckplasma (ca. $10^5$ K) der molekulare Wasserstoff ($H_2$) nahezu vollständig dissoziiert ist. Im Hochdruckplasma läuft somit vorwiegend Reaktion (2) ab, weshalb damit im Plasma überwiegend atomarer Wasserstoff (H) vorliegt.

Atomares Titan weist bekanntermaßen eine hohe Affinität zu Sauerstoff auf, wodurch Titanoxid gebildet wird. Durch den hohen Anteil an Edelgas in dem Hochdruckplasma wird eine Bildung von Titanoxid verhindert. Zur Verhinderung einer Bildung von Titanoxid ist es selbstverständlich auch möglich, zusätzlich den Arbeitsraum mit einem Edelgas zu fluten.

Die erfindungsgemäße Vorrichtung wird zur Beschichtung von Bauteilen für den Leichtbau, insbesondere für Faserbauteilen aus Ti-MMC (Titan-Metall-Matrix-Composite) für den Einsatz in Fluggasturbinen verwendet.

In einer vorteilhaften Ausführung der erfindungsgemäßen Vorrichtung sind drei Hochdruck-Plasmabrenner derart zueinander angeordnet, dass die Plasmabrenner einen Winkel von 120° zueinander bilden. Dadurch wird eine optimale und homogene Beschichtung der Faser erzielt. Selbstverständlich ist es auch möglich, dass mehr als drei Plasmabrenner symmetrisch zueinander angeordnet werden.

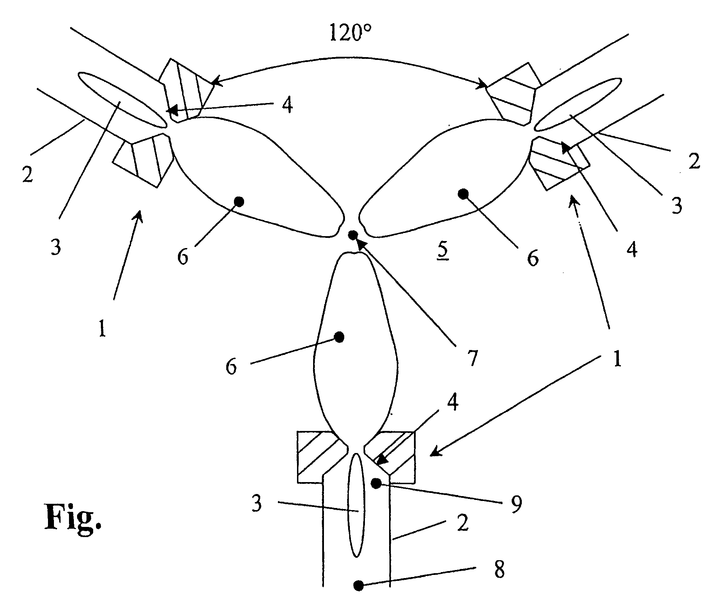

Die einzige Zeichnung zeigt eine beispielhafte Ausführung der erfindungsgemäßen Vorrichtung mit drei Plasmabrennern. In einem Hochdruck-Plasmabrenner 1 wird in einem Arbeitsrohr 2 ein elektrodenloses Hochdruckplasma 3 erzeugt, welches mittels einer Düse 4 in den Arbeitsraum 5 als Plasmastrahl 6 geleitet wird. Das Hochdruckplasma (3) wird mittels Zünden eines Prozessgases erzeugt, welches durch die Gaseintrittsöffnung (8) des Arbeitsrohrs (2) geleitet wird. Zusätzlich werden die Flüssig- und/oder Feststoffprecursoren durch die Gaseintrittsöffnung 8 des Arbeitsrohrs 2 dem Prozessgas und somit dem Hochdruckplasma 3 zugeführt. Dadurch erfolgt insbesondere bei der Verwendung von Feststoffprecursoren eine optimale Aufschmelzung der Partikel.

Die Hochdruck-Plasmabrenner 1 sind unter einem Winkel von 120° zueinander angeordnet, wobei sich die Plasmastrahlen 6 der verschiedenen Hochdruck-Plasmabrenner 1 in dem Punkt treffen, in dem die zu beschichtende Siliziumkarbidfaser 7 verläuft. Dadurch wird eine homogene Beschichtung der Siliziumkarbidfaser 7 gewährleistet.

**Patentansprüche**

1. Vorrichtung zur Beschichtung von Siliziumkarbidfasern mit einer Titanbasislegierung mittels Hochdruck-Plasmaspritzen, **dadurch gekennzeichnet, dass** mindestens zwei Hochdruck-Plasmabrenner (1) mit jeweils einem elektrodenlos erzeugten und mittels Mikro- oder Radiowellen aufrechterhaltenen Plasmastrahl (6) symmetrisch derart zueinander angeordnet sind, dass sich die Plasmastrahlen (6) zumindest in einem Punkt treffen, durch den die zu beschichtenden Siliziumkarbidfasern (7) geführt werden, und dass jeder Hochdruck-Plasmabrenner (1) eine Düse (4) für den Austritt des Plasmastrahls (6) aufweist.

2. Vorrichtung nach Anspruch 1, **dadurch gekennzeichnet, dass** drei Hochdruck-Plasmabrenner (1) vorhanden und derart angeordnet sind, dass sie einen Winkel von 120° zueinander aufweisen.

3. Vorrichtung nach Anspruch 1 oder 2, **dadurch gekennzeichnet, dass** jeder Hochdruck-Plasmabrenner (1) derart ausgeführt ist, dass die Titanbasislegierung als Feststoff- und/oder Flüssigprecursor zuführbar ist, letzteres insbesondere in Form von Titantetrachlorid.

**Claims**

1. A device for coating silicon carbide fibres with a titanium-based alloy by means of high pressure plasma spraying,
   **characterised in that**
   at least two high pressure plasma burners (1), each with a plasma jet (6) generated without an electrode and maintained by means of micro or radio waves, are positioned symmetrically in relation to one another in such a manner that the plasma jets (6) meet at at least one point through which the silicon carbide fibres (7) to be coated are fed, and that each high pressure plasma burner (1) has a nozzle (4) through which the plasma jet (6) is emitted.

2. A device in accordance with claim 1,
   **characterised in that**
   three high pressure plasma burners (1) are present and positioned in such a manner that they form an angle of 120°.

3. A device in accordance with claim I or 2,
   **characterised in that**
   each high pressure plasma burner (1) is designed in such a manner that the titanium-based alloy may be fed in as a solid and/or liquid precursor, the latter particularly in the form of titanium chloride.

**Revendications**

1. Dispositif pour revêtir des fibres en carbure de silicium avec un alliage à base de titane, au moyen de projections au plasma haute pression, **caractérisé en ce que** au moins deux torches à plasma haute pression (1) avec respectivement un jet de plasma (6) produit sans électrodes et maintenu au moyen de micro-ondes ou d'ondes radio-électrique sont disposées symétriquement les unes par rapport aux autres de telle manière que les jets de plasma (6) se rencontrent au moins en un point, à travers lequel sont guidées les fibres en carbure de silicium (7) à revêtir et de telle manière que chaque torche à plasma haute pression (1) présente un injecteur (4) pour la sortie du jet de plasma (6).

2. Dispositif selon la revendication 1, **caractérisé en ce que** l'on a trois torches à plasma haute pression (1) disposées de telle manière qu'elles présentent un angle de 120° les unes par rapport aux autres.

3. Dispositif selon la revendication 1 ou 2, **caractérisé en ce que** chaque torche à plasma haute pression (1) est réalisée de telle manière que l'alliage à base de titane peut être alimenté comme précurseur de matière solide et/ou liquide, ce dernier en particulier sous la forme de tétrachlorure de titane.

Fig.